(19) **Europäisches Patentamt**

**European Patent Office**

**Office européen des brevets**

(11) **EP 0 836 272 B1**

(12) **FASCICULE DE BREVET EUROPEEN**

(45) Date de publication et mention
de la délivrance du brevet:
**23.02.2005 Bulletin 2005/08**

(51) Int Cl.⁷: **H03F 3/45**, H03F 1/26

(21) Numéro de dépôt: **97410113.1**

(22) Date de dépôt: **08.10.1997**

(54) **Montage à faible bruit d'un amplificateur**

Rauscharme Verstärkungsanordnung

Low-noise amplifier arrangement

(84) Etats contractants désignés:
**DE FR GB IT**

(30) Priorité: **08.10.1996 FR 9612412**

(43) Date de publication de la demande:
**15.04.1998 Bulletin 1998/16**

(73) Titulaire: **DOLPHIN INTEGRATION (Société Anonyme)**
**F-38242 Meylan (FR)**

(72) Inventeur: **Compagne, Eric**
**38920 Crolles (FR)**

(74) Mandataire: **de Beaumont, Michel**
**1, rue Champollion**
**38000 Grenoble (FR)**

(56) Documents cités:
**GB-A- 2 281 160**    **US-A- 3 528 024**
**US-A- 4 215 317**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

La présente invention concerne un montage à faible bruit d'un amplificateur. L'invention s'applique, de façon générale, quelle que soit la fonction (amplification, intégration, inversion d'un signal d'entrée, etc.) dévolue à l'amplificateur dans le montage. Un exemple d'application de la présente invention concerne la réalisation d'un montage intégrateur à faible bruit à partir d'un amplificateur différentiel.

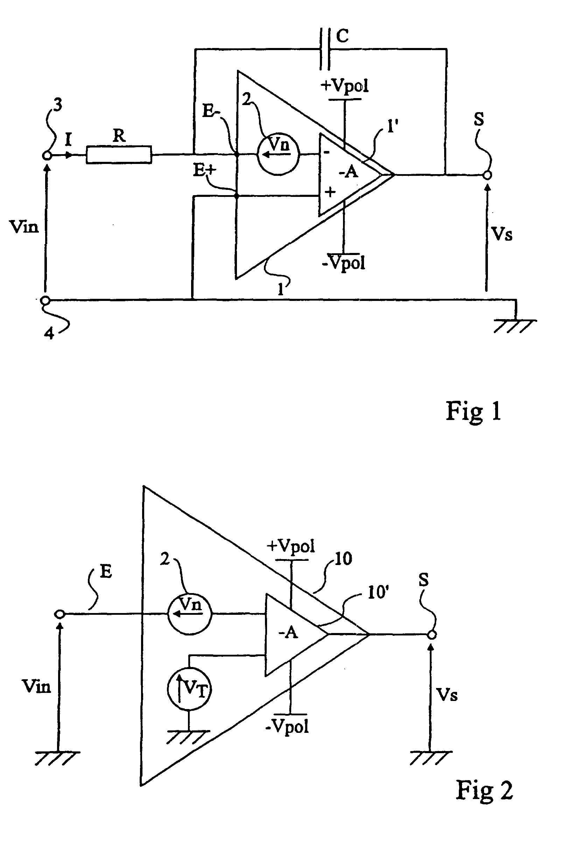

La figure 1 représente un schéma classique d'un tel montage intégrateur. Ce montage comporte un amplificateur différentiel 1 dont une borne E+ d'entrée non-inverseuse est raccordée à un potentiel médian (par exemple, la masse) entre des potentiels d'alimentation de l'amplificateur 1, respectivement +Vpol et -Vpol. Une borne E- d'entrée inverseuse de l'amplificateur 1 reçoit, par exemple, par l'intermédiaire d'une résistance R, un signal d'entrée Vin. La tension Vin est appliquée entre deux bornes d'entrée 3 et 4 du montage, la borne 4 étant à la masse. Une sortie de l'amplificateur 1 constitue une borne S de sortie du montage intégrateur. Un condensateur C est placé entre les bornes E- et S.

A la figure 1, on a modélisé l'amplificateur différentiel 1 sous la forme d'un amplificateur parfait 1' de gain en boucle ouverte -A, dont l'entrée inverseuse est reliée à un générateur 2 de tension de bruit Vn. Le générateur 2 symbolise le bruit de l'amplificateur 1 ramené sur son entrée inverseuse.

La qualité de l'intégration réalisée par le montage dépend, en particulier, du signal aux bornes du condensateur C qui est fonction du courant I circulant dans la résistance R. Si l'amplificateur 1 était parfait, le courant I serait égal à Vin/R. En réalité, l'amplificateur 1 étant bruité, le courant I dépend également de la tension Vn. En outre, la tension de bruit Vn se retrouve amplifiée dans le signal de sortie $V_S$ par le gain en tension -A de l'amplificateur ($V_S = -A(Vin - Vn)$).

Plusieurs solutions classiques peuvent être utilisées pour réduire le bruit de l'amplificateur.

Une solution connue consiste à augmenter la taille des transistors constitutifs de l'amplificateur 1 et le courant de polarisation. Outre l'augmentation de la surface de silicium nécessaire pour réaliser l'amplificateur sous forme de circuit intégré, cette solution présente l'inconvénient d'augmenter les capacités parasites, ce qui entraîne une diminution de la vitesse de l'amplificateur à répondre à une variation du signal d'entrée.

Dans certains montages, la résistance R est remplacée par une capacité commutée. Le signal d'entrée Vin se trouve alors échantillonné. Les solutions classiques ne permettent pas de minimiser l'influence du bruit tout en prévoyant un intégrateur de rapidité suffisante pour que la fréquence d'échantillonnage du signal d'entrée puisse être élevée. Pour arriver à une solution satisfaisante, on est amené à réduire le gain de l'amplificateur.

Plus généralement, le problème lié au bruit se pose dans tout montage réalisé à partir d'un amplificateur qu'il soit ou non à entrée différentielle et que sa sortie soit ou non différentielle.

La figure 2 représente un amplificateur 10 à entrée non-différentielle modélisé, comme à la figure 1, par un amplificateur parfait 10' associé à un générateur 2 de tension de bruit. La distinction entre les schémas des figures 1 et 2 réside dans le fait que l'amplificateur 10 n'a qu'une entrée E. La tension $V_T$ correspond ici à la tension de basculement d'un inverseur ou à la différence de tension nécessaire entre la borne E et le potentiel de polarisation -Vpol pour rendre l'amplificateur (le ou les transistors présents entre la borne E et le potentiel -Vpol) conducteur dans le cas d'un amplificateur simple. La tension de bruit Vn et la composante continue $V_T$ se trouvent amplifiées dans le signal de sortie $V_S$ par le gain en tension de l'amplificateur ($V_S = -A(Vin-Vn-V_T)$).

La présente invention vise à proposer un montage intégrateur réalisé à partir d'un amplificateur, qui minimise l'influence du bruit de l'amplificateur sur le signal de sortie, tout en ayant un gain élevé.

L'invention vise également à proposer un montage qui puisse fonctionner sous de faibles tensions d'alimentation et avec un faible courant de polarisation.

L'invention vise également à proposer un montage particulièrement adapté à un intégrateur à capacité commutée.

Pour atteindre ces objets, la présente invention prévoit un montage comportant un amplificateur principal, et un moyen pour créer, au moins pendant certaines périodes, un potentiel de référence flottant d'application d'au moins un signal d'entrée sur au moins une première borne d'entrée de l'amplificateur principal, ce potentiel de référence étant asservi sur le bruit de l'amplificateur principal ramené sur son entrée.

Selon un mode de réalisation de la présente invention, ledit moyen est constitué d'un amplificateur secondaire dont au moins une première borne d'entrée est reliée directement à la première borne d'entrée de l'amplificateur principal et dont au moins une borne de sortie définit le potentiel de référence.

Selon un mode de réalisation de la présente invention, l'amplificateur secondaire a un gain en tension inférieur et voisin de l'unité.

Selon un mode de réalisation de la présente invention, l'amplificateur principal comporte une borne d'entrée unique.

Selon un mode de réalisation de la présente invention, l'amplificateur principal est un amplificateur à entrées différentielles dont une borne d'entrée non-inverseuse est connectée à un potentiel médian entre deux potentiels d'alimentation, respectivement plus positif et plus négatif, une entrée inverseuse constituant la première borne d'entrée de l'amplificateur principal.

Selon un mode de réalisation de la présente invention, le montage constitue un intégrateur, l'entrée inverseuse de l'amplificateur principal étant reliée, par l'intermédiaire d'une impédance, à une borne de sortie de l'amplificateur principal constituant une borne de sortie du montage.

Selon un mode de réalisation de la présente invention, le signal d'entrée appliqué sur la première borne d'entrée de l'amplificateur principal correspond à un signal à traiter, appliqué sur une première borne d'entrée du montage.

Selon un mode de réalisation de la présente invention, une impédance d'entrée est connectée entre une première borne d'entrée du montage recevant un signal à traiter et la première borne d'entrée de l'amplificateur principal.

Selon un mode de réalisation de la présente invention, la borne de sortie de l'amplificateur secondaire constitue une deuxième borne d'application du signal à traiter.

Selon un mode de réalisation de la présente invention, l'amplificateur principal est un amplificateur à entrées et sorties différentielles, chaque entrée recevant un signal d'entrée ; l'amplificateur secondaire est à entrées et sorties différentielles, chaque sortie définissant un potentiel flottant d'application d'un des signaux d'entrée ; et chaque entrée de l'amplificateur principal est reliée directement à une entrée de l'amplificateur secondaire.

Selon un mode de réalisation de la présente invention, chaque entrée de l'amplificateur principal étant reliée, par l'intermédiaire d'une impédance, à une borne de sortie de l'amplificateur principal constituant une borne de sortie du montage.

Selon un mode de réalisation de la présente invention, deux impédances d'entrée sont respectivement connectées entre des bornes du montage recevant chacune un signal différentiel à traiter et une borne d'entrée de l'amplificateur principal.

Selon un mode de réalisation de la présente invention, chaque borne de sortie de l'amplificateur secondaire constitue une deuxième borne d'application du signal à traiter.

Selon un mode de réalisation de la présente invention, le montage comporte des moyens de commutation propres à déconnecter périodiquement la ou les impédances d'entrée de la borne d'entrée de l'amplificateur principal à laquelle elle est associée, le signal d'entrée de l'amplificateur principal étant référencé au potentiel de référence pendant les périodes où la ou les impédances d'entrée sont connectées.

Selon un mode de réalisation de la présente invention, les amplificateurs principal et secondaire sont alimentés par des potentiels identiques.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 et 2 décrites précédemment sont destinées à exposer l'état de la technique et le problème posé ;

la figure 3 représente un premier mode de réalisation d'un montage à faible bruit selon la présente invention ;

la figure 4 représente un schéma équivalent d'un montage intégrateur selon la présente invention ;

la figure 5 représente un premier mode de réalisation d'un montage intégrateur à capacité commutée selon la présente invention ;

la figure 6 représente un deuxième mode de réalisation d'un montage intégrateur à capacité commutée selon l'invention ;

la figure 7 représente un mode de réalisation d'un amplificateur secondaire d'un montage à faible bruit selon la présente invention ;

la figure 8 représente un troisième mode de réalisation d'un montage à faible bruit selon la présente invention ; et

la figure 9 représente un mode de réalisation d'un montage intégrateur différentiel à capacités commutées selon la présente invention.

Pour des raisons de clarté, les mêmes éléments ont été désignés par les mêmes références aux différentes figures.

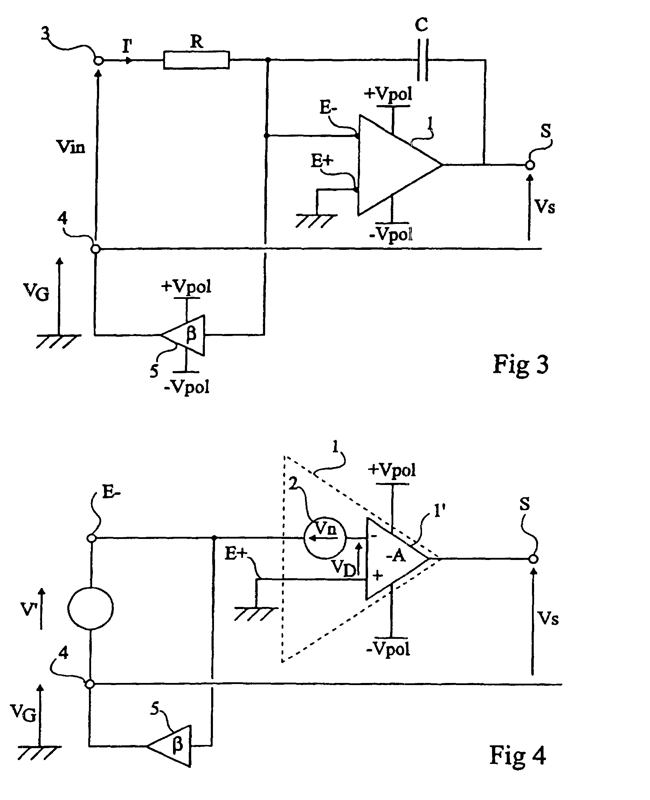

La figure 3 représente un premier mode de réalisation de la présente invention, appliqué à un montage intégrateur dans lequel un signal d'entrée Vin à traiter est appliqué par l'intermédiaire d'une résistance R. Comme précédemment, l'intégrateur est réalisé à partir d'un amplificateur différentiel 1, similaire à celui de la figure 1. Une borne E- d'entrée inverseuse de l'amplificateur 1 est reliée à une borne de sortie S par l'intermédiaire d'un condensateur C. La borne S constitue la sortie du montage. Une borne E+ non-inverseuse de l'amplificateur 1 est connectée à un potentiel médian entre deux potentiels de polarisation +Vpol et -Vpol de l'amplificateur 1.

Le potentiel +Vpol constitue le potentiel d'alimentation le plus positif et le potentiel -Vpol constitue le potentiel d'alimentation le plus négatif. Dans l'exemple représenté, les potentiels +Vpol et -Vpol sont égaux en valeur absolue (par exemple, 2,5 volts) et la borne E+ est connectée à la masse. Toutefois, d'autres valeurs peuvent être choisies. Par exemple, +Vpol = 3 volts et -Vpol = 0 volt (la masse), la borne E+ étant connectée à un potentiel de 1,5 volts.

Un signal à traiter Vin est appliqué entre des bornes 3 et 4 d'entrée du montage. La borne 3 est reliée, par l'intermédiaire de la résistance R, à la borne E-. Une caractéristique de ce mode de réalisation est que la borne 4 n'est plus connectée au même potentiel que la borne E+. Selon ce mode de réalisation, la borne 4 est portée à un potentiel de référence $V_G$ qui s'adapte automatiquement en fonction du bruit de l'amplificateur 1.

Plus généralement, une caractéristique de la présente invention est de référencer, au moins pendant certaines périodes, le signal appliqué à l'entrée de l'amplificateur à un potentiel flottant $V_G$ fonction du bruit de l'amplificateur.

Pour ce faire, le montage comporte également, selon l'invention, un amplificateur secondaire 5 dont une borne d'entrée est reliée directement à la borne E- de l'amplificateur 1 et dont une borne de sortie S' est reliée à la borne 4. De préférence, la tension de sortie $V_S$ du montage est également référencée par rapport au potentiel $V_G$.

Selon l'invention, le gain en tension $\beta$ de l'amplificateur 5 est inférieur et proche de l'unité. De préférence, l'amplificateur 5 est alimenté par les potentiels +Vpol et -Vpol d'alimentation de l'amplificateur 1.

Le rôle de l'amplificateur 5 est double. D'une part, il améliore le gain en boucle ouverte du montage intégrateur. D'autre part, il minimise l'influence du bruit de l'amplificateur 1. Ces caractéristiques seront mieux comprises en relation avec la figure 4. La figure 4 représente un montage simplifié d'un comparateur recevant un signal à traiter V', directement sur l'entrée E-. Cette figure constitue également une représentation partielle du montage de la figure 3, en boucle ouverte et dans lequel l'association de la tension Vin et de la résistance R a été représentée sous la forme d'un générateur de tension V' connecté entre les bornes E- et 4.

A la figure 4, l'amplificateur 1 est représenté sous la forme schématique d'un amplificateur parfait 1' de gain en boucle ouverte -A, associé à un générateur de bruit 2 sur son entrée inverseuse. La tension d'erreur entre les entrées inverseuse et non-inverseuse de l'amplificateur 1' a été désignée par $V_D$.

On peut établir les relations suivantes entre les tensions V', $V_S$, $V_D$ et $V_G$ :

$$V_S + V_G = -A.V_D \; ;$$

$$V' + V_G - V_n = V_D \; ;$$

et

$$V_G = \beta(V_n + V_D).$$

En reportant $V_G$ dans les deux premières relations et en combinant ces dernières pour éliminer $V_D$, on obtient :

$$V_S = [(A+\beta)/(\beta-1)]V' + A.Vn.$$

Comme le gain $\beta$ est voisin de 1, le signal d'entrée V' est considérablement plus amplifié que le bruit Vn alors que, dans un montage classique, le bruit Vn subit le même gain en tension que le signal utile V'. En effet, dans un montage classique tel que représenté à la figure 1, on aurait $V_S$ = -A(V'-Vn).

Un avantage de la présente invention est que le bruit ramené entre les bornes d'entrée E- et 4 est atténué d'un facteur $\beta$-1. Ainsi, plus l'amplificateur secondaire 5 a un gain proche de 1, plus le bruit ramené à l'entrée du montage est faible. Par conséquent, l'influence du bruit Vn sur le courant I' circulant dans la résistance R (figure 3), donc sur le signal aux bornes du condensateur C, est minimisée. La qualité de l'intégration est donc améliorée.

On notera que le gain $\beta$ de l'amplificateur 5 doit être inférieur à l'unité. En effet, si ce gain est supérieur à 1, le montage de la figure 3 devient instable car l'amplificateur 5 se trouve en boucle avec la résistance R et la tension d'entrée Vin. A titre d'exemple particulier de réalisation, le gain de l'amplificateur 5 est compris entre 0,9 et 0,99.

Un avantage de la présente invention est que, pour un gain en tension donné du montage, l'amplificateur 1 peut être réalisé avec un gain intrinsèque plus faible que dans un montage classique. En effet, le gain de l'amplificateur 1 est divisé par $\beta$-1, proche de 0. Ainsi, il est possible de réduire le nombre d'étages de l'amplificateur 1 par rapport à un montage classique. On peut ainsi minimiser le nombre d'étages de transistors en -cascade- constitutifs de l'amplificateur 1 tout en obtenant, pour le montage, un gain élevé en boucle ouverte. Outre le fait que cela minimise le bruit Vn qui est lié au nombre de transistors de l'amplificateur, cela réduit la tension d'alimentation minimale nécessaire au fonctionnement du montage. On peut donc réaliser un amplificateur à faible bruit alimenté sous une faible tension, par exemple de l'ordre de 3 volts.

Un autre avantage de la présente invention est que, puisque le gain intrinsèque de l'amplificateur est réduit, on peut, pour des caractéristiques de bruit données, utiliser des transistors plus bruyants pour réaliser l'amplificateur 1, ce qui réduit le coût du montage.

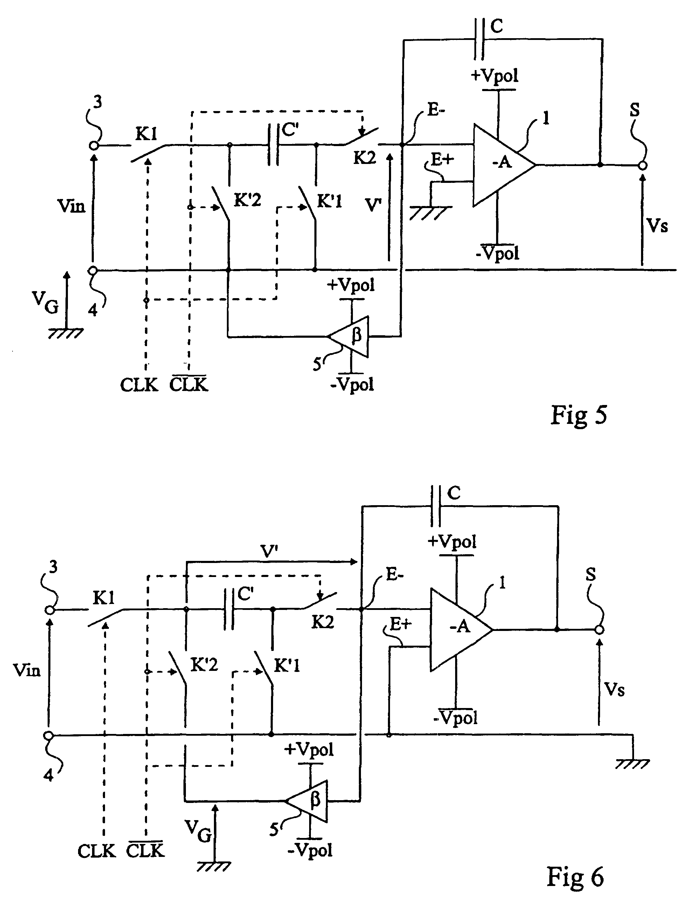

La figure 5 représente un premier mode de réalisation d'un montage intégrateur selon la présente invention dans lequel la résistance R (figure 3) est remplacée par un montage à capacité commutée.

Dans un tel montage, un premier commutateur K1 est monté en série avec un condensateur C' et un deuxième commutateur K2, entre les bornes 3 et E-. Chaque borne du condensateur C' est en outre reliée à la borne 4 par un commutateur, respectivement K'1 et K'2. Le reste du montage est similaire au montage décrit en relation avec la figure 3. Les commutateurs K1 et K'1 et les commutateurs K2 et K'2 sont fermés en alternance. Par exemple, les commutateurs K1 et K'1 sont commandés par un signal d'horloge CLK tandis que les commutateurs K2 et K'2 sont commandés par un signal $\overline{\text{CLK}}$ correspondant au signal CLK inversé. La tension V' d'entrée E- de l'amplificateur 10, référencée au potentiel $V_G$, est présente pendant les périodes où les commutateurs K2 et K'2 sont fermés.

La figure 6 représente un deuxième mode de réalisation d'un montage intégrateur selon l'invention. Une distinction par rapport aux montages des figures 3 à 5 est que le signal à traiter Vin est référencé à la masse. La tension V' appliquée à l'entrée E- de l'amplificateur 1 est cependant toujours référencée au potentiel $V_G$ fixé par l'amplificateur secondaire. En effet, la tension V' sur l'entrée E- est présente uniquement pendant les périodes où les commutateurs K2 et K'2 sont fermés. La borne E- est isolée de la tension Vin référencée à la masse, que ce soit par le commutateur K1 ou par le condensateur C'.

Au moyen d'un montage selon l'invention, le compromis antagoniste bruit-gain-vitesse est résolu car la vitesse est assurée par l'amplificateur principal 1 tandis que l'influence du bruit est minimisée par l'amplificateur secondaire 5 et que le gain est assuré par l'ensemble des deux amplificateurs ($\approx$ A/$\beta$-1).

L'amplificateur 5 est particulièrement simple à réaliser car il ne nécessite que peu de composants et que ses tensions d'entrée et de sortie ont des amplitudes très faibles (de l'ordre de quelques millivolts). Le bruit du montage dépend désormais de l'amplificateur secondaire 5. Ce bruit est très faible car cet amplificateur 5 comporte très peu de composants.

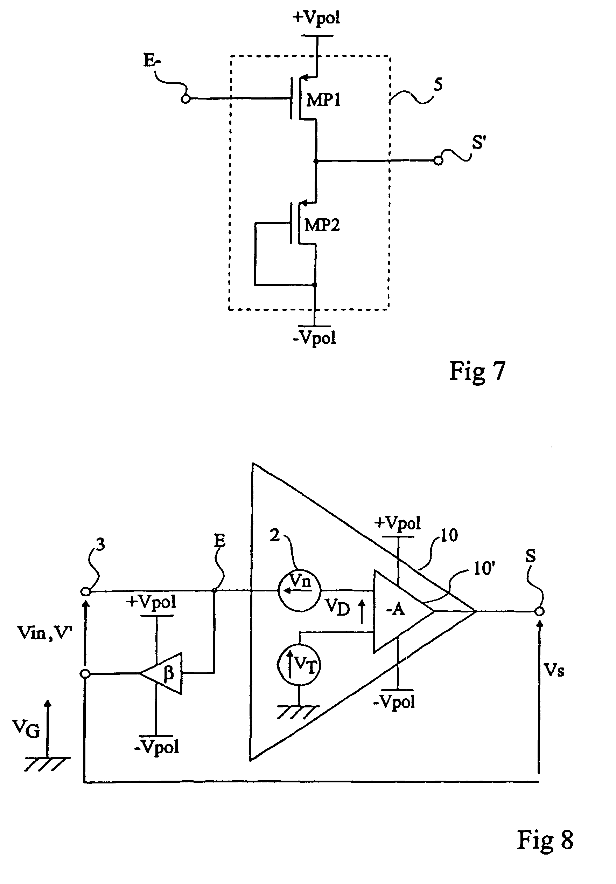

La figure 7 représente un mode de réalisation d'un amplificateur secondaire 5 non-différentiel selon la présente invention. L'amplificateur 5 est constitué de deux transistors MOS à canal P MP1 et MP2, montés en série entre les potentiels de polarisation +Vpol et -Vpol. La source du transistor MP1 est connectée au potentiel +Vpol. Son drain constitue la borne de sortie S'. La grille du transistor MP1 constitue la borne d'entrée reliée à la borne E-. La source du transistor MP2 est reliée au drain du transistor MP1. La grille du transistor MP2 est reliée à son drain, lui-même connecté au potentiel -Vpol. Le gain $\beta$ de l'amplificateur 5 est fixé par la relation suivante :

$$\beta = gm1 (rds1 // 1/gm2) = gm1/[(1/rds1) + gm2],$$

où gm1 et gm2 représentent les gains en transconductance respectifs des transistors MP1 et MP2, et où rdsl représente la résistance drain-source du transistor MP1 à l'état passant.

Comme l'inverse de la transconductance d'un transistor MOS est généralement nettement inférieure à sa résistance drain-source, le gain $\beta$ est voisin de 1 si les transistors MP1 et MP2 sont identiques. De plus, le gain $\beta$ est alors toujours inférieur à 1, le numérateur de la relation étant toujours inférieur au dénominateur.

La figure 8 représente un mode de réalisation de la présente invention appliqué à un amplificateur 10 à entrée unique (non différentiel). La borne E d'entrée de l'amplificateur 10 est reliée, par l'intermédiaire d'un amplificateur secondaire 5 tel que décrit précédemment, à la borne 4 qui n'est désormais plus reliée à la masse du montage. Le signal à traiter Vin (correspondant ici à V') est appliqué entre les bornes 3 et 4, la borne 4 étant au potentiel flottant $V_G$. Les relations décrites précédemment en relation avec la figure 4 se transposent à ce montage en tenant compte du seuil continu $V_T$ de basculement (ou de conduction) de l'amplificateur 10. Ainsi, on obtient la relation :

$$V_S = [(A + \beta)/(\beta - 1)]V' + A(Vn + V_T).$$

Si le montage de la figure 8 sert, par exemple, d'inverseur dont le seuil de basculement est centré entre +Vpol et -Vpol, on a $V_T = 0$. Si le montage de la figure 8 sert, par exemple, de simple amplificateur du signal V', la tension $V_T$ correspond au seuil de conduction de l'amplificateur, par exemple, la tension seuil d'un transistor MOS dont la grille constitue la borne E, dont le drain constitue la borne S reliée par l'intermédiaire d'une source de courant au potentiel +Vpol, et dont la source est au potentiel Vpol. On notera que la borne E peut, également dans ce cas, être reliée à la borne 3 par une impédance d'entrée.

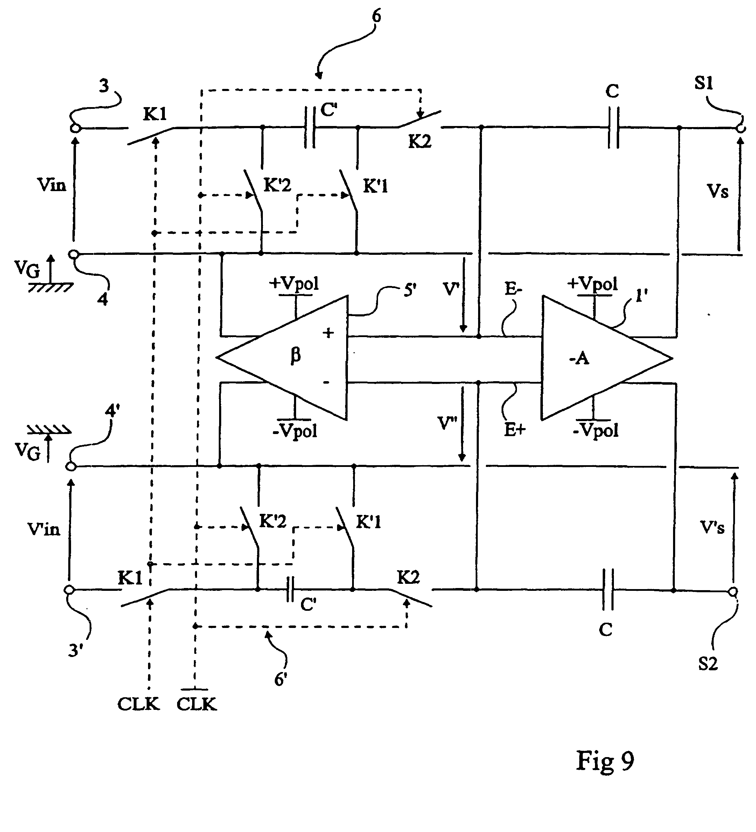

La figure 9 représente un mode de réalisation d'un montage entièrement différentiel selon la présente invention. Dans l'exemple représenté à la figure 9, il s'agit d'un montage intégrateur à capacités commutées du type de celui de la figure 5.

L'amplificateur principal 1' de la figure 9 est pourvu de deux sorties S1, S2 différentielles et chaque sortie est reliée à une entrée, respectivement E-, E+, par l'intermédiaire d'un condensateur C. Le montage comprend deux bornes 3, 3' d'application du signal à traiter. Ce signal est, en raison de la structure différentielle, découplé de façon classique en deux signaux Vin, V'in respectivement appliqués aux bornes 3 et 3'. Il s'agit toutefois du même signal. Chaque entrée E-, E+ de l'amplificateur 1' est associée à un montage 6, 6' à capacité commutée. Chaque montage comprend, comme à la figure 5, un commutateur K1 en série avec un condensateur C' et un commutateur K2, entre les bornes 3 et E-, respectivement, 3' et E+.

Selon la présente invention, chaque entrée E-, E+ de l'amplificateur 1' est également reliée à une entrée, respectivement non-inverseuse (+) et inverseuse (-) d'un amplificateur secondaire 5' à sorties différentielles. Chaque sortie de l'amplificateur 5' est reliée à une borne 4, 4' d'application de la tension, respectivement Vin, V'in du signal à traiter. Ainsi, l'amplificateur 5' définit, sur les deux bornes 4, 4', un potentiel de référence $V_G$ asservi sur le bruit de l'amplificateur 1' ramené sur son entrée, et les tensions V', V'' appliquées aux entrées E-, E+ de l'amplificateur 1' sont toujours référencées au potentiel $V_G$.

Le fonctionnement du montage représenté à la figure 9 se déduit de celui exposé en relation avec la figure 5. On notera que le potentiel de référence flottant $V_G$ a la même valeur sur les bornes 4 et 4', le montage étant parfaitement symétrique.

On notera également qu'un montage intégrateur tel que représenté à la figure 3 ou à la figure 6, peut également être adapté en montage entièrement différentiel de façon similaire, chaque montage différentiel pouvant être divisé en deux parties symétriques respectivement associées aux potentiels positif et négatif.

On notera en outre que la mise en oeuvre de l'invention ne nécessite aucune modification de l'étage de sortie qu'il s'agisse d'un montage à base d'un amplificateur à sortie unique ou différentielle. En effet, l'invention intervient uniquement sur l'étage d'entrée.

Bien entendu, la présente invention est susceptible de diverses variantes et modifications qui apparaîtront à l'homme de l'art. En particulier, le choix des potentiels d'alimentation +Vpol et -Vpol des amplificateurs du montage dépend de l'application particulière à laquelle est destiné l'intégrateur. De plus, la réalisation pratique de l'amplificateur principal 1 utilise des techniques classiques qui sont à la portée de l'homme de l'art et, dans le cas où le montage comporte une impédance d'entrée, il pourra s'agir d'un élément résistif, capacitif ou inductif, ou d'une combinaison d'éléments de ce type.

**Revendications**

1. Montage comportant :

   un amplificateur principal (1, 1', 10), recevant sur au moins une première borne d'entrée (E-, E) un signal d'entrée ; et
   un amplificateur secondaire (5, 5') dont au moins une première borne d'entrée est reliée directement à ladite première borne d'entrée de l'amplificateur principal et dont au moins une borne de sortie (S') est reliée directement à une borne de référence de potentiel (4) pour l'application dudit signal d'entrée, ladite borne de référence de potentiel (4) servant aussi pour référencer la tension de sortie (VS) du montage, pour créer, au moins pendant certaines périodes, un potentiel de référence flottant ($V_G$) d'application du signal d'entrée et asservir ce potentiel sur le bruit (Vn) de l'amplificateur principal ramené sur son entrée.

2. Montage selon la revendication 1, **caractérisé en ce que** l'amplificateur secondaire (5, 5') a un gain en tension (β) inférieur et voisin de l'unité.

3. Montage selon la revendication 1 ou 2, **caractérisé en ce que** ledit amplificateur principal (10) comporte une borne d'entrée (E) unique.

4. Montage selon la revendication 1 ou 2, **caractérisé en ce que** l'amplificateur principal est un amplificateur (1) à entrées différentielles (E-, E+) dont une borne (E+) d'entrée non-inverseuse est connectée à un potentiel médian entre deux potentiels d'alimentation, respectivement plus positif (+Vpol) et plus négatif (-Vpol), une entrée inverseuse (E-) constituant ladite première borne d'entrée de l'amplificateur principal (1).

5. Montage selon la revendication 4, **caractérisé en ce qu'**il constitue un montage intégrateur, ladite entrée inverseuse (E-) de l'amplificateur principal (1) étant reliée, par l'intermédiaire d'une impédance (C), à une borne de sortie (S) de l'amplificateur principal constituant une borne de sortie du montage.

6. Montage selon l'une quelconque des revendications 1 à 5, **caractérisé en ce que** le signal d'entrée appliqué sur la première borne d'entrée (E-, E) de l'amplificateur principal (1, 10) correspond à un signal (V') à traiter, appliqué sur une première borne (3) d'entrée du montage.

7. Montage selon l'une quelconque des revendications 1 à 5, **caractérisé en ce qu'**une impédance d'entrée (R, C') est connectée entre une première borne (3) d'entrée du montage recevant un signal (Vin) à traiter et la première borne d'entrée (E-) de l'amplificateur principal (1).

8. Montage selon la revendication 7 ou 8, **caractérisé en ce que** ladite borne de sortie (S') de l'amplificateur secondaire (5) constitue une deuxième borne (4) d'application du signal à traiter (Vin, V').

9. Montage selon la revendication 1 ou 2, **caractérisé en ce que** :

   l'amplificateur principal est un amplificateur (1') à entrées (E-, E+) et sorties (S1, S2) différentielles, chaque entrée (E-, E+) recevant un signal d'entrée (V', V") ;
   l'amplificateur secondaire (5') est à entrées et sorties différentielles, chaque sortie définissant un potentiel flottant d'application d'un des signaux d'entrée ; et
   chaque entrée de l'amplificateur principal est reliée directement à une entrée de l'amplificateur secondaire.

10. Montage selon la revendication 9, **caractérisé en ce qu'**il constitue un montage intégrateur, chaque entrée (E-, E+) de l'amplificateur principal (5') étant reliée, par l'intermédiaire d'une impédance (C), à une borne de sortie (S1, S2) de l'amplificateur principal constituant une borne de sortie du montage.

11. Montage selon la revendication 9 ou 10, **caractérisé en ce que** deux impédances d'entrée (C') sont respectivement connectées entre des bornes (3, 3') du montage recevant chacune un signal différentiel (Vin, V'in) à traiter et une borne d'entrée (E-, E+) de l'amplificateur principal.

**12.** Montage selon la revendication 11, **caractérisé en ce que** chaque borne de sortie de l'amplificateur secondaire (5') constitue une deuxième borne (4, 4') d'application du signal à traiter (Vin, V'in).

**13.** Montage selon la revendication 7 ou 11, **caractérisé en ce qu'**il comporte des moyens de commutation (K1, K2, K'1, K'2) propres à déconnecter périodiquement la ou les impédances d'entrée (C') de la borne d'entrée (E-, E+) de l'amplificateur principal (1, 1') à laquelle elle est associée, ledit signal d'entrée (V', V") de l'amplificateur principal étant référencé audit potentiel de référence ($V_G$) pendant les périodes où la ou les impédances d'entrée (C') sont connectées.

**14.** Montage selon l'une quelconque des revendications 1 à 13, **caractérisé en ce que** les amplificateurs principal (1, 1', 10) et secondaire (5, 5') sont alimentés par des potentiels (+Vpol, -Vpol) identiques.

**Claims**

**1.** An arrangement comprising :

a main amplifier (1, 1', 10), receiving on at least one first input terminal (E-, E) an input signal; and
a secondary amplifier (5, 5') having at least one first input terminal directly connected to said first input terminal of the main amplifier and having at least one output terminal (S') directly connected to a reference voltage terminal (4) for application of said input signal, said reference voltage terminal being also used for referencing the output voltage ($V_S$) of the arrangement, to create, at least during some periods a floating reference voltage ($V_G$) for application of the input signal and servo-control of the voltage on the noise (Vn) of the main amplifier seen from the input thereof.

**2.** The arrangement of claim 1, wherein the secondary amplifier (5, 5') has a voltage gain (β) close to and smaller than unity.

**3.** The arrangement of claim 1 or 2, wherein said main amplifier (10) has a single input terminal (E).

**4.** The arrangement of claim 1 or 2, wherein the main amplifier is an amplifier (1) having differential inputs (E-, E+), wherein a non inverting input (E+) is connected to a median voltage between two supply voltages, respectively most positive (+Vpol) and most negative (-Vpol), and an inverting input (E-) constitutes said first input terminal of the main amplifier (1).

**5.** The arrangement of claim 4, constituting an integrating arrangement, said inverting input (E-) of the main amplifier (1) being connected, through an impedance (C), to an output terminal (S) of the main amplifier constituting an output terminal of the arrangement.

**6.** The arrangement according to any of claims 1 to 5, wherein the input signal applied to the first input terminal (E-, E) of the main amplifier (1, 10) corresponds to a signal (V') to process applied to a first input terminal (3) of the arrangement.

**7.** The arrangement according to any of claims 1 to 5, wherein an input impedance (R, C') is connected between a first input terminal (3) of the arrangement, receiving a signal (Vin) to process, and the first input terminal (E-) of the main amplifier (1).

**8.** The arrangement according to claim 6 or 7, wherein said output terminal (S') of the secondary amplifier (5) constitutes a second terminal (4) for applying the signal to process (Vin, V').

**9.** The arrangement of claim 1 or 2, wherein:

the main amplifier is an amplifier (1') having differential inputs (E-, E+) and outputs (S1, S2), each input (E-, E+) receiving an input signal (V', V");
the secondary amplifier (5') has differential inputs and outputs, each output defining a floating voltage for applying one of the input signals; and
each input of the main amplifier is connected directly to one input of the secondary amplifier.

**10.** The arrangement according to claim 9, forming an integrator arrangement wherein each input (E-, E+) of the main amplifier (5') is connected, through an impedance (C), to an output terminal (S1, S2) of the main amplifier, constituting an output terminal of the arrangement.

**11.** The arrangement according to claim 9 or 10, wherein two input impedances (C') are respectively connected between terminals (3, 3') of the arrangement receiving a differential signal (Vin, V'in) to process and an input terminal (E-, E+) of the main amplifier.

**12.** The arrangement of claim 11, wherein each output terminal of the secondary amplifier (5') constitutes a second terminal (4, 4') for applying the signal to process (Vin, V'in).

13. The arrangement according to claim 7 or 11, comprising switching means (K1, K2, K'1, K'2) operative to periodically disconnect the input impedances (C') from the input terminal (E-, E+) of the main amplifier (1, 1') to which it is associated, said input signal (V', V'') of the main amplifier being referenced to said reference voltage ($V_G$) during the periods where the impedances (C') are connected.

14. The arrangement according to any of claims 1 to 13, wherein the main (1, 1', 10) and secondary (5, 5') amplifiers are supplied by identical voltages (+Vpol, -Vpol).


**Patentansprüche**

1. Eine Anordnung, die Folgendes aufweist:

   einen Hauptverstärker (1, 1', 10) zum Empfang an mindestens einem ersten Eingangsanschluss (E-, E) eines Eingangssignals; und einen sekundären Verstärker (Sekundärverstärker) (5, 5') mit mindestens einem ersten Eingangsanschluss, direkt verbunden mit dem erwähnten ersten Eingangsanschluss des Hauptverstärkers und mindestens einem Ausgangsanschluss (S'), direkt verbunden mit einem Bezugsspannungsanschluss (4) zum Anlegen des erwähnten Eingangssignals, wobei der Bezugsspannungsanschluss auch verwendet wird, um die Ausgangsspannung ($V_S$) der Anordnung mit einem Bezug zu versehen, um mindestens während einiger Perioden eine schwebende Bezugsspannung ($V_G$) zu erzeugen, und zwar zum Anlegen des Eingangssignals und zur Servosteuerung der Spannung am Rauschen (Vn) des Hauptverstärkers, gesehen vom Eingang her.

2. Anordnung nach Anspruch 1, wobei der sekundäre Verstärker (5, 5') eine Spannungsverstärkung (β) nahe bei und kleiner als eins besitzt.

3. Anordnung nach Anspruch 1 oder 2, wobei der Hauptverstärker (10) einen einzigen Eingangsanschluss (E) besitzt.

4. Anordnung nach Anspruch 1 oder 2, wobei der Hauptverstärker ei Verstärker (1) ist, und zwar mit Differenzeingängen (E-, E+), wobei ein nichtinvertierender Eingang (E+) mit einer mittleren oder medialen Spannung zwischen zwei Versorgungsspannungen verbunden ist, und zwar der positivsten (+Vpol) bzw. der negativsten (-Vpol), und mit einem invertierenden Eingang (E-), der den ersten Eingangsanschluss des Hauptverstärkers (1) bildet.

5. Anordnung nach Anspruch 4, wobei diese eine Integrationsanordnung bildet, wobei der invertierende Eingang (E-) des Hauptverstärkers (1) durch eine Impedanz (C) mit einem Ausgangsanschluss (S) des Hauptverstärkers verbunden ist, der einen Ausgangsanschluss der Anordnung bildet.

6. Anordnung nach einem der Ansprüche 1 bis 5, wobei das an den ersten Eingangsanschluss (E-, E) des Hauptverstärkers (1, 10) angelegte Eingangssignal einem Signal (V') entspricht und zwar zur Verarbeitung angelegt an einen ersten Eingangsanschluss (3) der Anordnung.

7. Anordnung nach einem der Ansprüche 1 bis 5, wobei eine Eingangsimpedanz (R, C') zwischen einen ersten Eingangsanschluss (3) der Anordnung zum Empfang eines zu verarbeitenden Signals (Vin) und einen ersten Eingangsanschluss (E-) des Hauptverstärkers (1) geschaltet ist.

8. Anordnung nach Anspruch 6 oder 7, wobei der Ausgangsanschluss (S') des sekundären Verstärkers (5) einen zweiten Anschluss (4) zum Anlegen des zu verarbeitenden (Vin, V') Signals bildet.

9. Anordnung nach Anspruch 1 oder 2, wobei Folgendes vorgesehen ist: der Hauptverstärker ist ein Verstärker (1') mit Differenzeingängen (E-, E+) und Ausgängen (S1, S2), wobei jeder Eingang (E-, E+) ein Eingangssignal (V', V'') empfängt; der Sekundärverstärker (5') besitzt Differenzeingänge und -ausgänge wobei jeder Ausgang eine schwebende Spannung zum Anlegen eines der Eingangssignale definiert; und jeder Eingang des Hauptverstärkers ist direkt mit einem Eingang des Sekundärverstärkers verbunden.

10. Anordnung nach Anspruch 9, wobei die Anordnung eine Integrationsanordnung bildet, wobei jeder Eingang (E-, E+) des Hauptverstärkers (5') über eine Impedanz (C) mit einem Ausgangsanschluss (S1, S2) des Hauptverstärkers verbunden ist, und zwar einen Ausgangsanschluss der Anordnung bildend.

11. Anordnung nach Anspruch 9 oder 10, wobei zwei Eingangsimpedanzen (C') jeweils zwischen die Anschlüsse (3, 3') der Anordnung geschaltet sind, und zwar zum Empfang eines Differenzsignals (Vin, V'in) zur Verarbeitung und eines Eingangsanschlusses (E-, E+) des Hauptverstärkers.

12. Anordnung nach Anspruch 11, wobei jeder Ausgangsanschluss des Sekundärverstärkers (5') einen zweiten Anschluss (4, 4') zum Anlegen des Signals zur Verarbeitung (Vin, V'in) bildet.

13. Anordnung nach Anspruch 7 oder 11, wobei Schaltmittel (K1, K2, K'1, K'2) vorgesehen sind, die periodisch die Eingangsimpedanzen (C') von dem Eingangsanschluss (E-, E+) des Hauptverstärkers (1, 1') trennen mit dem sie assoziiert sind, wobei das Eingangssignal (V', V") des Hauptverstärkers mit der Bezugspannung ($V_G$) während der Perioden in Bezug steht, wo die Impedanzen (C') angeschlossen sind.

14. Anordnung nach einem der Ansprüche 1 bis 13, wobei die Haupt- (1, 1', 10) und Sekundär- (5, 5') Verstärker durch identische Spannungen (+Vpol, -Vpol) versorgt werden.

Fig 1

Fig 2

Fig 3

Fig 4

Fig 5

Fig 6

Fig 7

Fig 8

Fig 9